# EUROPEAN PATENT SPECIFICATION

(11) **EP 1 083 629 B1**
(45) Date of publication and mention of the grant of the patent: **01.06.2005**
(21) Application number: 00307273.3
(22) Date of filing: 23.08.2000
(51) Int. Cl.: H01R 12/04, H01R 12/36, H01R 43/16, H01R 43/24

(54) **Pin header and a method of making same**
Anschlussleiste mit Steckerstiften und Methode zur Herstellung dergleichen
Bloc de connexion et procédé pour sa fabrication

(30) Priority: 08.09.1999 JP 25382299
(43) Date of publication of application: 14.03.2001
(73) Proprietor: J.S.T. Mfg. Co., Ltd., Osaka, 542-0081 (JP)
(72) Inventor: Moriwake, Ryo, Izumiotsu-shi, Osaka (JP); Horiuchi, Hideaki, Suita-shi, Osaka (JP)
(74) Representative: DeVile, Jonathan Mark, Dr.

(56) References cited:
- US-A- 4 802 860
- PATENT ABSTRACTS OF JAPAN vol. 1995, no. 06, 31 July 1995 (1995-07-31) & JP 07 085932 A (FUJITSU LTD), 31 March 1995 (1995-03-31)

## Description

### FIELD OF THE INVENTION

The present invention relates to a pin header. Illustrative embodiments of the present invention relate to pin headers designed to be surface mounted on a printed circuit board, and more particularly to a pin header comprising a plurality of pin contacts that are arranged in parallel upper and lower rows and through an insulating housing. Further embodiments of the present invention relate to a method of making this type of pin header, wherein the housing is of a rectangular parallelepiped shape and insert-molded using the pin contacts that serve as inserts to be embedded in the molded housing.

### BACKGROUND OF THE INVENTION

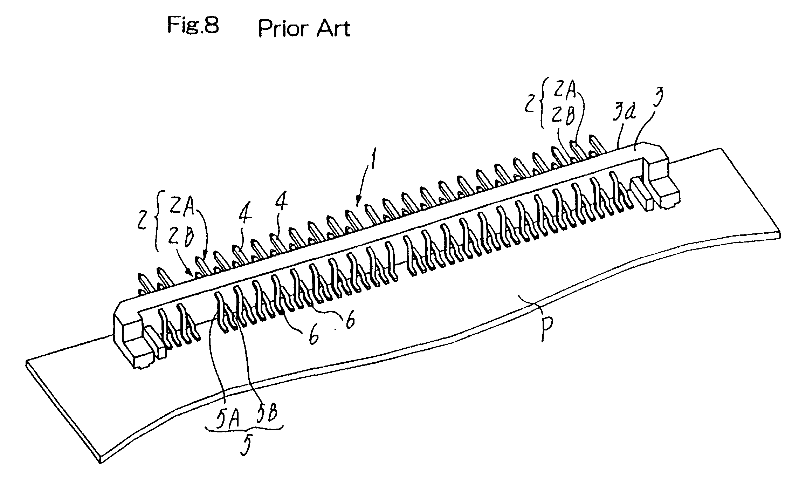

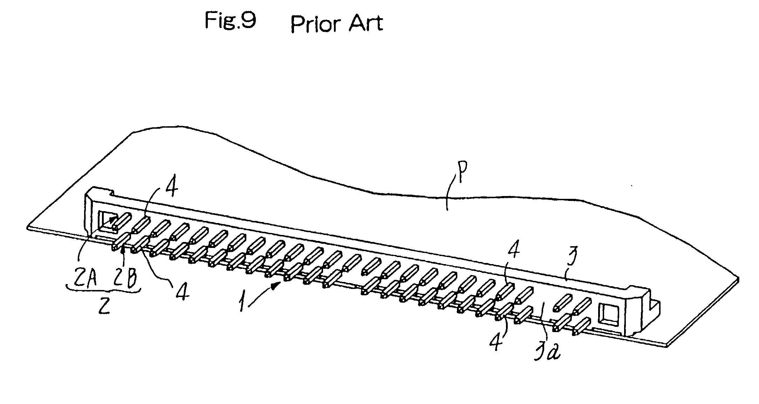

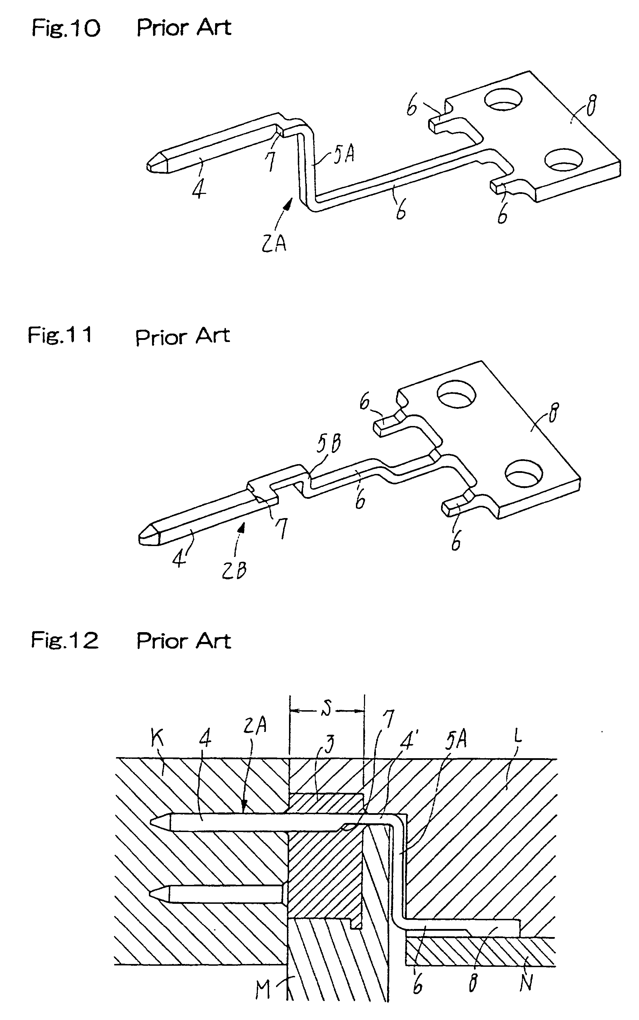

Figs. 8 and 9 show an example of the prior art pin header 1. This pin header has a plurality of pin contacts 2 that form upper and lower rows in an insulating housing 3. The housing is generally of a parallelepiped shape and insert-molded with the plurality of pin contacts 2 each penetrating it. Each pin contact 2 is composed of a plugging rod 4 extending horizontally, a leg 5A or 5B and a generally straight and horizontal extension 6, all integral with each other. The plugging rod 4 protruding from a front face 3a of the housing 3 has a rear end that is exposed on a rear face of this housing. The rear end is bent downwards generally at a right angle to provide the leg 5A or 5B. Each leg has its lower end continuing at a right angle to the horizontal and straight extension 6 that is to be surface-mounted on a printed circuit board 'P'. Those legs 5A, which the pin contacts 2A forming the upper row near the upper face of the housing 3 do have, are much longer than the other legs 5B which the other contacts 2B forming the lower row have. As will be seen in Figs. 10 and 11, formed in the rear end of each plugging rod 4 is such a shoulder 7 as thinning a rearward region of each contact 2A and 2B. Thus, each leg 5A and 5B as well as each rear straight extension 6 are made thinner than the body of each plugging rod. A crosspiece 8 formed integral with rearward ends of the extensions 6 holds the upper or lower contacts 2A and 2B at a regular pitch while insert molding them in the housing 3, until being subsequently cut off to provide a finished product.

The insert molding of the housing 3 with upper and lower contacts 2A and 2B will be carried out as shown in Fig. 12, wherein each upper contact 2A with a longer leg 5A is retained at three pints. In detail, a mold segment 'K' holds therein the contact's plugging rod 4, whilst other segments 'L' and 'M' grip the rod's rear end 4', with the segment 'L' and another segment 'N' griping the crosspiece 8. Due to a considerably long distance from the rear ends 4' to the common crosspiece, the upper contacts have been likely to make unintentional movement within the mold. Consequent distortion of the housing 3 in position as a whole has adversely affected 'coplanarity' of the straight extensions 6 affixed to the circuit board. If thickness 'S' of the housing 3 were reduced in a fore and aft direction to provide a thinnest possible pin header 1, then this problem would be more serious. Such a reduced thickness 'S' has caused another problem that the housing 3 could not surely hold the pin contacts 2, failing to protect their shoulders 7 from breakage against torsion or a bending stress imparted to the rods 4 when plugging them in sockets.

### SUMMARY OF THE INVENTION

Embodiments of the present invention seek to provide an improved pin header and a method of making same, wherein contacts forming an tipper row do scarcely make any unintentional movement while being insert molded and the resultant pin header is protected in its entirety from positional distortion. Embodiments also seek to provide a pin header that does not only ensure 'coplanarity' of its rear, horizontal and straight extensions but also have plugging rods resistant to torsion or a bending stress, so that the pin header can be made thinner in dimension.

According to a first aspect of the present invention there is provided a pin header according to claim 1.

Preferably, a shoulder may be formed in a middle region of the leg so as to render each leg and each rear straight extension thinner than the body of each plugging rod.

According to another aspect of the present invention there is provided a method according to claim 4.

### BRIEF DESCRIPTION OF THE DRAWINGS

Fig. 1 is a rear perspective view of a pin header provided in accordance with an embodiment of the present invention;
Fig. 2 is a frontal perspective view of a pin header;
Fig. 3 is a perspective view of one of pin contacts forming an upper row in the pin header;
Fig. 4 is a perspective view of one of the other pin contacts forming a lower row in the pin header;
Fig. 5 is a vertical cross section of a mold used in an embodiment to insert-mold an insulating housing in which the upper pin contact of the pin header has been placed;
Fig. 6 also is a vertical cross section of the mold used in another embodiment for the same purpose;
Fig. 7 is likewise a vertical cross section of the mold used in still another embodiment for the same purpose;
Fig. 8 is a rear perspective view of the prior art pin header;
Fig. 9 is a frontal perspective view of the prior art pin header;
Fig. 10 is a perspective view of one of pin contacts forming an upper row in the prior art pin header;
Fig. 11 is a perspective view of one of the other pin contacts forming a lower row in the prior art pin header; and
Fig. 12 is a vertical cross section of a mold used in the prior art to insert-mold an insulating housing in which the upper pin contact of the pin header has been placed.

### THE PREFERRED EMBODIMENTS

Now, some preferable embodiments of the present invention will be described below referring to the drawings.

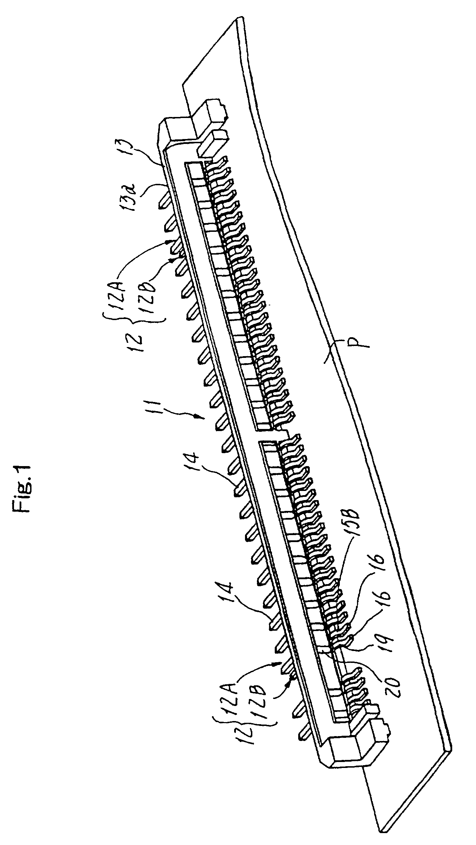

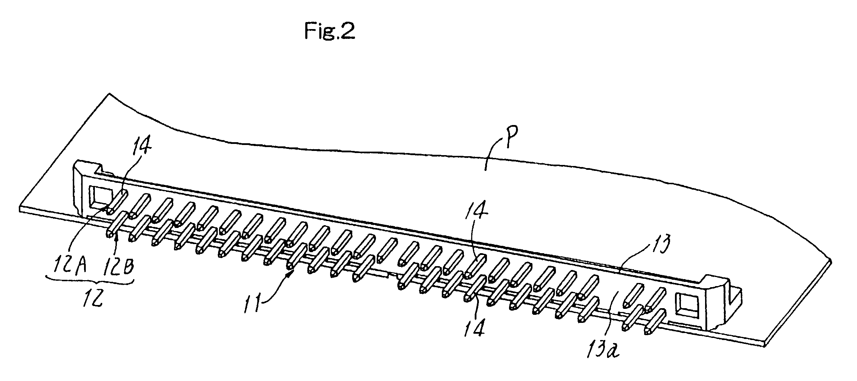

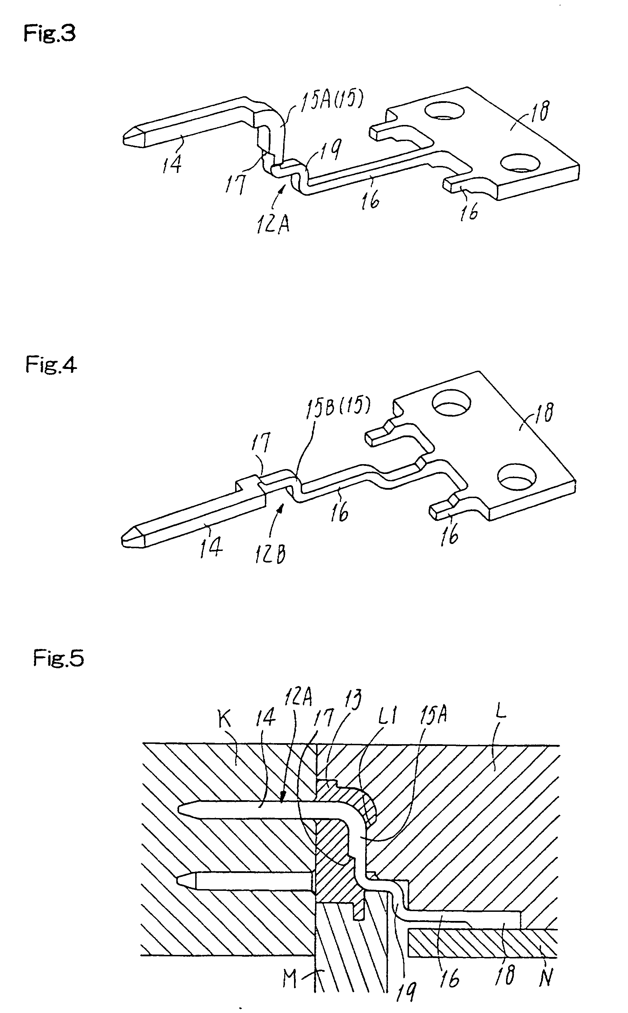

Figs. 1 and 2 show a pin header 11 of an embodiment of the present invention. A plurality of pin contacts 12 constituting this header are arranged in and through an insulating housing 13. This housing of a parallelepiped shape is insert-molded, with those pin contacts being previously set in place to form an upper row and a lower row prior to the molding of said housing. Each pin contact 12 is composed of a plugging rod 14, a leg 15 and a straight extension 16. The plugging rod 14 to be plug in a mating socket not shown does protrudes from a frontal face 13a of the housing 13. The plugging rod has a rear end protruding rearwardly of the housing, with this rear end being bent downwards generally at a right angle to provide the leg 15 (see Figs. 3 and 4). This leg has a lower end bent outwards also generally at a right angle so as to provide the straight extension 16 extending horizontally to be surface mounted on a printed circuit board 'P'. Similarly to the prior art pin header shown in Figs. 8 to 11, each upper contact 12A included in the upper row in the housing 13 has its leg 15A longer than that 15B of each lower contact 12B. The rear ends of the horizontal extensions 16 are integral with a common crosspiece 18.

However, each upper pin contact 12A has characteristically an intermediate step 19, as best seen in Fig. 3. This step 19 located at a corner between the leg 15A and the rear extension 16 is formed by bending the leg 15A outwards generally at a right angle so as to have an outer end, and further bending downwards this outer end also generally at a right angle. Such an intermediate step 19 is of a shape similar to or corresponding to the leg 15B of the lower pin contact 12B. A shoulder 17 is formed at a middle height of the leg 15A so as to render its lower portion and the extension 16 relatively thinner than the body of plugging rod. Thus, an upper portion of the leg 15A continuing downwards from the plugging rod 14 and located above said shoulder 17 is of the same thickness as that of said rod.

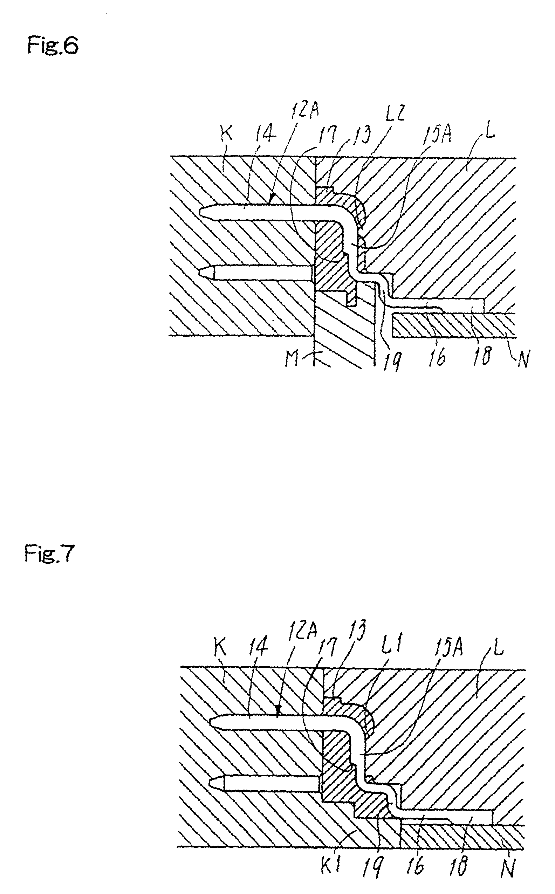

Fig. 5 shows how to insert mold the housing 13 in which the upper contact 12A has previously been placed. A mold segment 'K' supports the plugging rod 14, and further mold segments 'L' and 'M' grip the intermediate step 19 between them. The crosspiece 18 is gripped by and between one of the further segment 'L' and a still further segment 'N', so as to hold the upper contact 12A at three points. Additionally, a rear surface area of the leg 15A bears against a rib 'L1' of the further segment 'L', thereby affording four-point support for said contact 12A. After setting the contact in the mold in this manner, a resin will be injected into a cavity appearing between the mold segments 'K', 'L' and 'M' so as to form the housing 13. By insert molding the housing, the leg 15A will also be embedded in the resin, except for its rear surface area contacting the segment's rib 'L1'. As a result, such rear surface areas of the legs 15A will be exposed outsides, forming a plurality of elongate groove-shaped openings 20 in the rear face of the housing 13. On the other hand, the intermediate steps 19 will protrude rearwardly from the housing 13, together with the straight horizontal extensions 16.

Fig. 6 shows a modified embodiment wherein the rear surface area of each leg 15A is kept in a pointed contact with a lug 'L2' of the mold segment 'L' while insert molding the upper contacts 12A. This structure of the mold will almost completely embed each leg 15A in the housing 13.

Fig. 7 shows another embodiment wherein the embodiment shown in Fig. 6 is further modified such that the mold segment 'M' is dispensed with. In this case, an extension 'K1' from the segment 'K' cooperates with the segment 'L' to grip the intermediate steps 19. This mold will produce a housing 13 that supports also the lower portion of each intermediate step 19, thereby further enhancing protection of the legs 15A from unintentional movement.

Each lower pin contact 12B (see Fig. 4) has, similarly to the upper one 12A, a shoulder 17 disposed intermediate opposite ends of the leg 15B so as to improve resistance to torsion or bending stress. However, those contacts 12B are of almost the same configuration as the lower contacts 2B in the prior art, making useless any further discussion.

It will now be apparent that the pin header 11 of the present invention is insert molded while its tipper contacts 12A are supported at four points within the assembly of mold segments 'K', 'L', 'M' and 'N'. Unintentional movement of each upper contact is now diminished during the step of insert molding the header, thereby surely protecting it from being warped and improving 'coplanarity' of the straight horizontal extensions 16. Each leg 15A is embedded in the housing 13 so that the housing can now hold the plugging rods in place more firmly. Since the shoulder 17 for thinning the leg and extension is disposed intermediate the opposite ends of each leg 15A, the rod 14 will now be more resistant to torsion or a bending stress that is imparted to it when plugged into a mating socket. The housing 13 can now be successfully reduced in thickness in fore and aft direction to provide a thinner pin header 11, without impairing its 'coplanarity' and strength.

In summary, the pin header provided herein is advantageous in that the upper pin contacts are inhibited from making unintentional movement during the step of insert molding, whereby the housing is now prevented from becoming warped. Coplanarity of the straight extensions as well as torsion or bending strength of the plugging rods are now improved to enable manufacture of thinner pin headers.

The method set forth in the accompanying claims makes it easy to manufacture thinned pin headers.

## Claims

1. A pin header comprising: a plurality of pin contacts (12A, 12B); an insulating housing (13) generally of a parallelepiped shape and insert-molded with the pin contacts each penetrating the housing, the pin contacts (12A,12B)forming an upper row and a lower row in the insulating housing (13), each pin contact composed of a plugging rod (14) extending horizontally from a front face of the housing, a leg (15A,15B) and a generally straight, rearward and horizontal extension (16), all integral with each other, the plugging rod (14) protruding from a front face of the housing and having a rear end on a rear face of the housing (13), with the rear end being bent downwards generally at a right angle to provide the leg (15A,15B); and each leg having its lower end continuing at a right angle either directly or indirectly to the rearward horizontal extension (16) that is to be surface-mounted on a printed circuit board (P),
**characterized in that** only those plugging rods of the pin contacts forming the lower row in the housing are exposed on the rear face of the housing and only those legs (15A) of the pin contacts (12A) forming the upper row in the housing (13) have each an intermediate step (19) at a corner between the leg (15A) and the horizontal extension (16), the intermediate step (19) being formed by twice-bending each leg outwardly at first at a right angle and then downwards also at a right angle,
and **in that** the legs (15A) of the pin contacts (12A) forming the upper row are embedded in the housing (13), with the intermediate step (19) of each contact being exposed outside together with the rearward horizontal extension (16).

2. A pin header as defined in claim 1, **characterized in that** each leg (15A) in the upper row has its rear surface area exposed outsides and rearwardly of the housing (13).

3. A pin header as defined in claim 1 or 2, **characterized in that** wherein a shoulder (17) is formed in a middle region of the leg (15A,15B) so as to render each leg and each rear straight extension (16) thinner than the body of each plugging rod (14).

4. A method for manufacturing a pin header, comprising the steps of:
preparing pin contacts (12A,12B) whose rearward horizontal extensions (16) to be surface-mounted on a printed circuit board (P) are arranged at a predetermined pitch and in parallel with each other and are integrally connected to a common crosspiece (18);
setting the pin contacts (12A,12B) in an injection mold so as to form therein an upper row and a lower row; and
finally insert-molding an insulating housing (13) so that plugging rods (14) of the contacts continue from respective legs (15A,15B) and protrude forwardly of the housing, with the rearward extensions (16) either directly or indirectly continuing from the legs and protruding rearwardly of said housing,
**characterized in that** the contacts (12A) forming the upper row in the housing (13) have each an intermediate step (19) at a corner between the leg (15A) and the horizontal extension (16), wherein the intermediate step (19) is formed by twice-bending each leg (15A) outwardly at first at a right angle and then downwards also at a right angle,
and **in that** during the step of insert molding the housing (13) each contact (12A) forming the upper row is kept supported at four points in and by the mold, that is, at its plugging rod (14), at its rear surface area of the leg (15A), at its intermediate step (19) and at the crosspiece (18), whereby the entirety of each leg (15A) except for its rear surface area supported on a portion of the mold is embedded in the insulating housing (13) thus molded.

5. The method as defined in claim 4, **characterized in that** a shoulder (17) is formed in a middle region of the leg (15A,15B) so as to render each leg and each rear straight extension (16) thinner than the body of each plugging rod (14).

## Patentansprüche

1. Anschlußleiste mit Steckerstiften mit: einer Vielzahl von Stiftkontakten (12A, 12B); einem Isoliergehäuse (13) von im allgemeinen parallelepipedischer Gestalt, welches einpreßgeformt ist, wobei die Stiftkontakte jeder das Gehäuse durchdringen, die Stiftkontakte (12A, 12B) eine obere Reihe und eine untere Reihe in dem Isoliergehäuse (13) bilden, wobei jeder Stiftkontakt aus einem Steckstab (14) besteht, der sich von einer Vorderfläche des Gehäuses horizontal erstreckt, einem Schenkel (15A, 15B) und einer im allgemeinen geraden hinteren und horizontalen Verlängerung (16) besteht, die alle einstückig miteinander sind, der Steckstab (14) aus einer Vorderfläche des Gehäuses vorsteht und auf einer hinteren Fläche des Gehäuses (13) ein hinteres Ende hat, welches im allgemeinen unter einem rechten Winkel nach unten gebogen ist, um den Schenkel (15A, 15B) vorzusehen; und wobei das untere Ende jedes Schenkels sich unter einem rechten Winkel entweder direkt oder indirekt zu der hinteren horizontalen Verlängerung (16) fortsetzt, die auf der Oberfläche einer gedruckten Leiterschaltung (P) montiert werden soll,
**dadurch gekennzeichnet, daß** nur jene Steckstäbe der Stiftkontakte, welche die untere Reihe in dem Gehäuse bilden, auf der hinteren Fläche des Gehäuses frei liegen und nur jene Schenkel (15A) der Stiftkontakte (12A), welche die obere Reihe in dem Gehäuse (13) bilden, jeder eine Zwischenstufe (19) an einer Ecke zwischen dem Schenkel (15A) und der horizontalen Verlängerung (16) haben, wobei die Zwischenstufe (19) durch zweimaliges Biegen jedes Schenkels zuerst nach außen unter einem rechten Winkel und dann nach unten auch unter einem rechten Winkel gebildet wird, und
daß die Schenkel (15A) der Stiftkontakte (12A), welche die obere Reihe bilden, in dem Gehäuse (13) eingebettet sind, wobei die Zwischenstufe (19) jedes Kontaktes außen zusammen mit der hinteren horizontalen Verlängerung (16) frei liegt.

2. Anschlußleiste mit Steckerstiften nach Anspruch 1, **dadurch gekennzeichnet, daß** der hintere Flächenbereich jedes Schenkels (15A) in der oberen Reihe außen und rückwärtig vom Gehäuse (13) frei liegt.

3. Anschlußleiste mit Steckerstiften nach Anspruch 1 oder 2, **dadurch gekennzeichnet, daß** in einem Mittelbereich des Schenkels (15A, 15B) eine Schulter (17) gebildet ist, um jeden Schenkel und jede hintere gerade Verlängerung (16) dünner zu machen als der Körper jedes Steckstabes (14).

4. Verfahren zur Herstellung einer Anschlußleiste mit Steckerstiften, welches folgende Schritte aufweist:
Vorbereiten von Stiften von Stiftkontakten (12A, 12B), deren hintere horizontale Verlängerungen (16), die auf der Oberfläche einer gedruckten Leiterplatte (P) montiert werden sollen, mit einer vorbestimmten Teilung und parallel zueinander angeordnet werden und einstückig mit einem gemeinsamen Querträger (18) verbunden werden;
Einsetzen der Stiftkontakte (12A, 12B) in eine Spritzform, um in dieser eine obere Reihe und eine untere Reihe zu bilden; und
schließlich Einpreßformen eines Isoliergehäuses (13), so daß sich Steckstäbe (14) der Kontakte von entsprechenden Schenkeln (15A, 15B) fortsetzen und nach vom von dem Gehäuse vorstehen, wobei sich die hinteren Verlängerungen (16) entweder direkt oder indirekt von den Schenkeln fortsetzen und nach hinten von dem Gehäuse vorstehen,
**dadurch gekennzeichnet, daß** die Kontakte (12A), welche die obere Reihe in dem Gehäuse (13) bilden, jeder eine Zwischenstufe (19) an einer Ecke zwischen dem Schenkel (15A) und der horizontalen Verlängerung (16) haben, wobei die Zwischenstufe (19) durch zweifaches Biegen jedes Schenkels (15A) zuerst nach außen unter einem rechten Winkel und dann nach unten auch unter einem rechten Winkel gebildet wird, und
daß während des Einpreßformens des Gehäuses (13) jeder die obere Reihe bildende Kontakt (12A) an vier Stellen in der Form und von dieser gehalten wird, d.h. an seinem Steckstab (14), an seinem hinteren Flächenbereich des Schenkels (15A), an seiner Zwischenstufe (19) und an dem Querträger (18), wodurch die Gesamtheit jedes Schenkels (15A) außer seinem hinteren Flächenbereich, der auf einem Abschnitt der Form gehalten wird, in dem somit geformten Isoliergehäuse (13) eingebettet wird.

5. Verfahren nach Anspruch 4, **dadurch gekennzeichnet, daß** in einem Mittelbereich des Schenkels (15A, 15B) eine Schulter (17) gebildet wird, um jeden Schenkel und jede hintere gerade Verlängerung (16) dünner zu machen als der Körper jedes Steckstabes (14).

## Revendications

1. Connecteur à broches comprenant : une pluralité de contacts à broches (12A, 12B), un cadre isolant (13) de forme générale parallélépipédique et moulé avec un insert, les contacts à broches pénétrant chacun dans le cadre, les contacts à broches (12A, 12B) formant une rangée supérieure et une rangée inférieure dans le cadre isolant (13), chaque contact à broche étant composé d'une tige d'enfichage (14) s'étendant horizontalement depuis une face avant du cadre, d'une patte (15A, 15B) et d'une extension généralement rectiligne, vers l'arrière et horizontale (16), tous étant intégrés les uns aux autres, la tige d'enfichage (14) dépassant d'une face avant du cadre et comportant une extrémité arrière sur une face arrière du cadre (13), l'extrémité arrière étant pliée vers le bas généralement à angle droit pour fournir la patte (15A, 15B), et chaque patte ayant son extrémité inférieure continuant à angle droit soit directement, soit indirectement par rapport à l'extension horizontale vers l'arrière (16) qui est montée en surface sur une carte à circuit imprimé (P),
**caractérisé en ce que** seules les tiges d'enfichage des contacts à broches formant la rangée inférieure dans le cadre sont exposées sur la face arrière du cadre et **en ce que** seules les pattes (15A) des contacts à broches (12A) formant la rangée supérieure dans le cadre (13) comportent chacune un décrochement intermédiaire (19) au niveau d'un coin entre la patte (15A) et l'extension horizontale (16), le décrochement intermédiaire (19) étant formé par un double pliage de chaque patte vers l'extérieur tout d'abord à angle droit et ensuite vers le bas également à angle droit,
et **en ce que** les pattes (15A) des contacts à broches (12A) formant la rangée supérieure sont incorporées dans le cadre (13), le décrochement intermédiaire (19) de chaque contact étant exposé vers l'extérieur de même que l'extension horizontale orientée vers l'arrière (16).

2. Connecteur à broches selon la revendication 1, **caractérisé en ce que** chaque patte (15A) de la rangée supérieure a sa zone de surface arrière exposée à l'extérieur et sur l'arrière du cadre (13).

3. Connecteur à broches selon la revendication 1 ou 2, **caractérisé en ce qu'**un épaulement (17) est formé dans une région intermédiaire de la patte (15A, 15B) de façon à rendre chaque patte et chaque extension droite arrière (16) plus fine que le corps de chaque tige d'enfichage (14).

4. Procédé de fabrication d'un connecteur à broches, comprenant les étapes consistant à :
préparer des contacts à broches (12A, 12B) dont les extensions horizontales vers l'arrière (16) devant être montées en surface sur une carte à circuit imprimé (P) sont agencées à un pas prédéterminé et parallèlement les unes aux autres et sont reliées solidairement à une traverse commune (18),
disposer les contacts à broches (12A, 12B) dans un moule à injection de façon à former dans celui-ci une rangée supérieure et une rangée inférieure, et
finalement mouler avec un insert un cadre isolant (13) de sorte que les tiges d'enfichage (14) des contacts se prolongent depuis les pattes respectives (15A, 15B) et dépassent vers l'avant du cadre, les extensions vers l'arrière (16) continuant soit directement, soit indirectement, depuis les pattes et dépassant sur l'arrière dudit cadre,
**caractérisé en ce que** les contacts (12A) formant la rangée supérieure du cadre (13) comportent chacun un décrochement intermédiaire (19) au niveau d'un coin entre la patte (15A) et l'extension horizontale (16), où le décrochement intermédiaire (19) est formé par un double pliage de chaque patte (15A) vers l'extérieur tout d'abord à angle droit et ensuite vers le bas, également à angle droit,
et **en ce que**, lors de l'étape de moulage avec un insert du cadre (13), chacun des contacts (12A) formant la rangée supérieure est maintenu supporté en quatre points dans le moule et par celui-ci, c'est-à-dire au niveau de sa tige d'enfichage (14), au niveau de sa zone de surface arrière de la patte (15A), au niveau de son décrochement intermédiaire (19) et au niveau de la traverse (18), grâce à quoi l'intégralité de chaque patte (15A), excepté pour sa zone de surface arrière supportée sur une partie du moule, est incorporée dans le cadre isolant (13) ainsi moulé.

5. Procédé selon la revendication 4, **caractérisé en ce qu'**un épaulement (17) est formé dans une région intermédiaire de la patte (15A, 15B) de façon à rendre chaque patte et chaque extension droite arrière (16) plus mince que le corps de chaque tige d'enfichage (14).
